(19) Europäisches Patentamt
European Patent Office
Office européen des brevets

(11) Publication number: **0 169 967**
**A2**

(12) # EUROPEAN PATENT APPLICATION

(21) Application number: 85102753.2

(22) Date of filing: 11.03.85

(51) Int. Cl.⁴: G 03 F 9/00

(30) Priority: 01.08.84 JP 162108/84
28.12.84 JP 279391/84

(43) Date of publication of application:
05.02.86 Bulletin 86/6

(84) Designated Contracting States:
CH DE FR GB LI

(71) Applicant: DAI NIPPON INSATSU KABUSHIKI KAISHA
1-1, Kaga-Cho 1-Chome Ichigaya Shinjuku-Ku
Tokyo 162(JP)

(72) Inventor: Tamura, Junichi
105-2-203, 1762 Oaza Yamaguchi
Tokorozawa-Shi Saitama-Ken(JP)

(72) Inventor: Uchiyama, Takashi
3-11-12, Kyodo
Setagaya-ku Tokyo-To(JP)

(74) Representative: Patentanwälte Dipl.-Ing. Klaus Behn
Dipl.-Phys. Robert Münzhuber
Widenmayerstrasse 6/IV
D-8000 München 22(DE)

(54) **Original angle setting device for scanner.**

(57) As one aspect of the present invention, it is characterized in that a magnification measurement operation is effected with a magnification measurement apparatus and therefore a base line and an original setting line which are required for angle setting can be automatically depicted on a transparent film or a paper without requiring other operations. As another aspect of the present invention, there is provided angle setting device wherein an original holder member assembled in an automatic magnification measurement apparatus is rotatably provided, an original holding member for inserting an original into the original holder with the original being put thereinto is formed elongated thereby holding a plurality of original thereinto, and the original holding member is removably inserted into the original holder so that the former is displaced relative to the latter to effect each angle setting of a plurality of original in sucession. As a further aspect of the invention, there is provided a device for making original setting angle indication gauge, which comprises means operative to form a pulse signal corresponding to an inclined angle of a original, and means operative to input a predetermined side number indicating which side of a original has been measured and a predetermined output number indicating that the original is mounted to which portion of a sheet line gauge, thereby selecting one format from several formats determined in advance based on inputs of the both means and calculating the length of a line segment to be plotted and coordinates to plot on a sheet, setting line showing a position at which a original is mounted based on the calculated result in accordance with a selected format.

FIG.I

3
6
5'
52'
1
8
10
4
2
9
I
B
7

EP 0 169 967 A2

# ORIGINAL ANGLE SETTING DEVICE FOR SCANNER

## BACKGROUND OF THE INVENTION

The present invention relates to an original angle setting device for a scanner.

In a color separation work using a scanner for a printing plate, a work for mounting a color original e.g. a color film onto a scanning drum of the scanner is required. In this instance, a mounting angle of the color original with respect to the scanning drum must be correctly set as designated by a rough sketch depicted on a block copy board or backing.

Such an original mounting angle setting is generally called an "angle setting". Hitherto, such an angle setting has been all in dependence on the eye measurement of an operator. Namely, an angle of inclination of a figure depicted on the block copy board is measured by means of e.g. a protractor to obtain an angle of the original with respect to the block copy board based on the measured value by means of e.g. a protractor in a manner similar to the above, then mounting the original onto the scanning drum based on the angle of the original thus measured.

However, the drawbacks with such a method based on the eye measurement are as follows; working skillfulness is required, resulting in low working efficiency, its precision is low and assurance of a desired precision is difficult and scores or scratches are likely to be occured on the surface of the scanning drum.

## SUMMARY OF THE INVENTION

With the above in view, an object of the present invention is to provide an angle setting device which can set each angle of a plurality of original in succession with a high precision, which can be easily handled without skillfulness, and which is inexpensive.

To achieve such an object, as one aspect of the present invention, it is characterized in that a magnification measurement operation is effected with a magnification measurement apparatus and therefore a base line and an original mounting line which are required for angle setting can be automatically depicted on a transparent film or a paper without requiring other operations.

As another aspect of the present invention there is provided an angle setting device wherein an original holder member assembled in an automatic magnification measurement apparatus is rotatably provided, an original holding member for inserting an original into the original holder with the original being put thereinto is formed elongated thereby holding a plurality of original thereinto, and the original holding member is removably inserted into the original holder so that the former is displaced relative to the latter to effect each angle setting of a plurality of original in succession.

As a further aspect of the invention, there is provided a device for making an original mounting angle indication gauge, which comprises means operative to form a pulse signal corresponding to an inclined angle of an original, and means operative to input a predetermined side number indicating which side of an original has been measured and a predetermined output number indicating that the original is mounted to which portion of a sheet like gauge, thereby selecting one format from several formats determined in advance based on inputs of the both means and calculating the length of a line segment to be plotted and coordinates to plot on a sheet, mounting line showing a position at which an original is stuck based on the calculated result in accordance with a selected format.

BRIEF DESCRIPTION OF THE DRAWINGS

FIG. 1 is a perspective view illustrating an embodiment of an original angle setting device for scanner,

FIGS. 2(a) and 2(b) are explanatory views showing a relationship between an original holding implement and an original holder in the embodiment of the invention,

FIG. 3 and FIGS. 4(a) to 4(c) are explanatory views showing the original holder in the embodiment of the invention,

FIGS. 5(a) to 5(d) are explanatory views showing an angle detection circuit and a coordinates transformation processing of original data in the embodiment of the invention,

FIG. 6 is a flowchart showing an operation of the embodiment according to the present invention,

FIG. 7 is a flowchart showing the detail of one step in the flowchart shown in FIG. 6,

FIGS. 7A(a) and 7A(b) are explanatory views for the operation shown in the flowchart of FIG. 7, respectively,

FIG. 8 is an explanatory view illustrating several examples of original sticking gauges of predetermined different formats,

FIGS. 9(a) and 9(b) are explanatory views illustrating how to select an original side to be measured and how to plot sticking lines in accordance with the selection of the original,

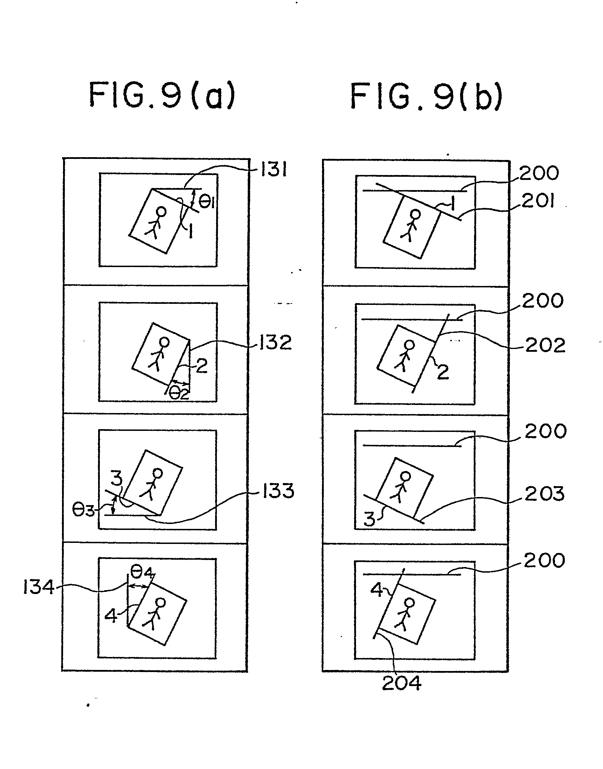

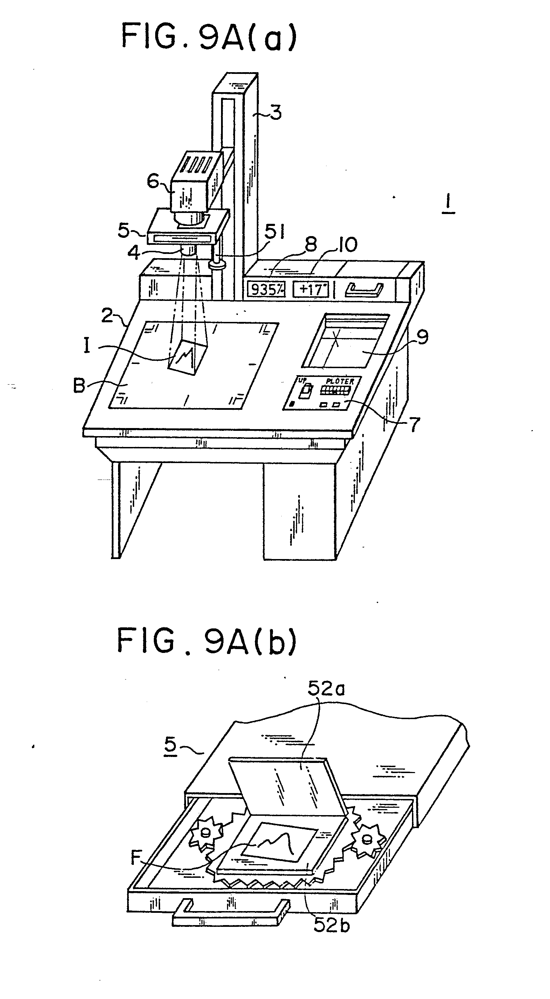

FIGS. 9A(a) and 9A(b) are perspective views illustrating another embodiment of the original angle setting device and an original holding member constituting of the device,

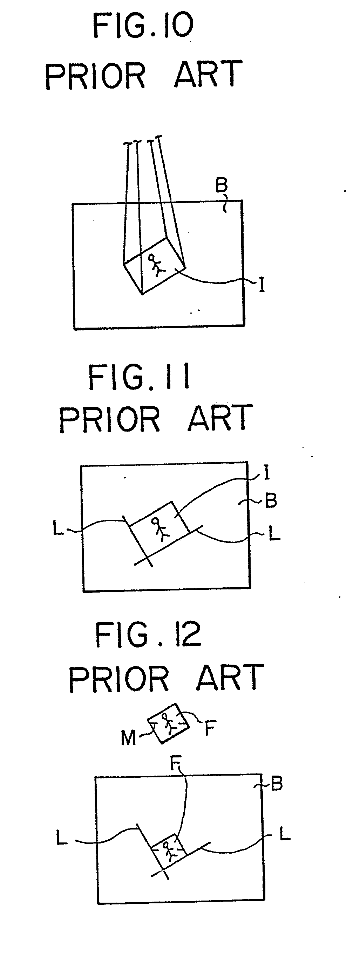

FIGS. 10 to 13 are explanatory views showing one example of an angle setting work carried out in the prior art, and

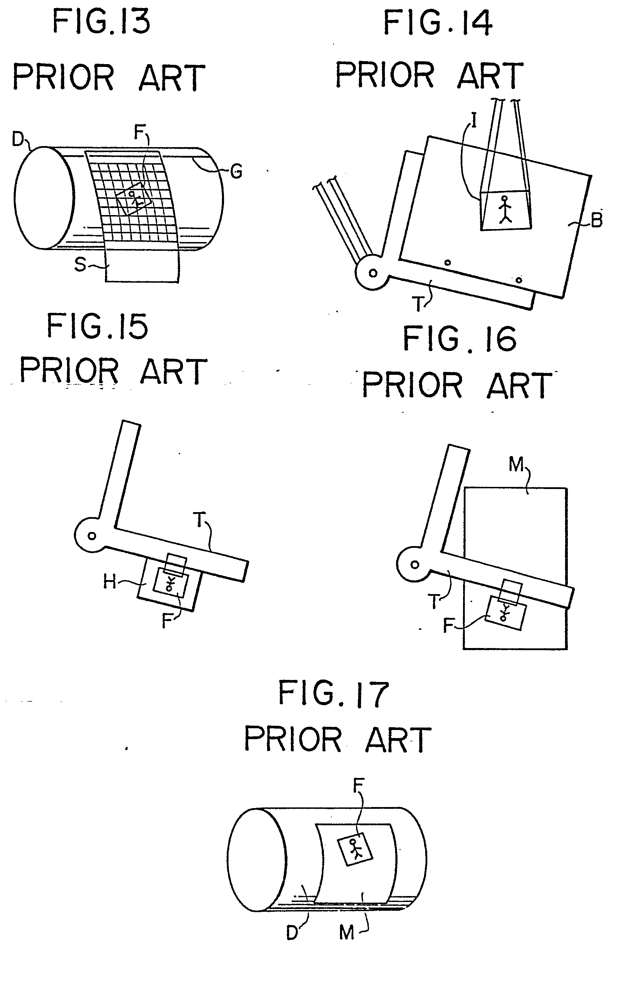

FIGS. 14 to 17 are explanatory views showing other examples of angle setting works in the prior art.

## DETAILED DESCRIPTION OF THE INVENTION

(Prior art)

A magnification measurement work is carried out as one of preprocessings required prior to color separation. For this purpose, devices called a "magnification measurement apparatus" have been widely used.

A method of effecting an angle setting work with such a magnification measurement apparatus was proposed from a fairly long ago and has been widely adapted.

Such a method is simply classified into two kinds of methods. One is to utilize the function of the magnification measurement apparatus without additional instruments. The other is to add an auxiliary instrument to the magnification measurement apparatus to effect measurement by making use of the auxiliary instrument.

First, one example of the former method will be described with reference to FIGS. 10 to 13.

(1) An original is set to the magnification measurement apparatus to implement a manipulation such that a projected image I of a pattern of the original corresponds to a rough sketch depicted on a block copy board B (FIG. 10). In this instance, the block copy board B is placed so that it is fixed at a regular position, thereby effecting a manipulation for coincidence between rough sketches depicted on a block copy board and the original by rotating only the projected image I of the original.

(2) Two straight lines L perpendicular to each other are drawn by hand on the block copy board B along frames (side edge portions) of the projected image I of the pattern formed on the original (FIG. 11).

(3) The original F which has been set to the magnification measurement apparatus is removed. Then, the original thus removed as mounted on the block copy board B so that side edge portions of the original F are arranged along the two hand-written lines drawn on the block copy board B. In this condition, a mark M indicating a horizontal position is depicted at the side edge portions of the original (FIG. 12).

(4) The original F is attached onto a scanning drum D of a scanner in a manner that the horizontal mark M is in parallel with a horizontal base line G formed on the scanning drum D of the scanner at a predetermined position thereof by making use of a sectioned film S etc. (FIG. 13).

However, with this method, most of the manipuration is manually effected, resulting in low working efficiency and further drawbacks are pointed out as follows.

a) Because of difficulty in ensuring a precision, work must be done with the greatest possible care.

b) Direct marking onto the original film is required. For this reason, there arises problems in the maintenance of the original, resulting in the possibility that dusts or rubbishes are attached thereon or there occurs damages.

c) It is required to depict a base line on the block copy (or its copy), giving rise to an increase in the number of working steps.

d) A sectioned film etc. is additionally required, requiring an extra time in dealing it.

Subsequently, one example of the latter method implemented with the auxiliary instrument will be described with reference to FIGS. 14 to 17. This method is characterized in that a square serving as a magnification measurement apparatus is provided in a manner that it can move to a desired position along an upper surface of a bed for mounting a block copy board thereon and rotate to a desired angle, thus effecting angle setting of an original by making use of the square. The work is carried out in accordance with the following procedures. The magnification measurement apparatus provided with such an auxiliary instrument is known as e.g. "SCAN MOUNT" (T.N.) manufactured by Dainihon Screen K. K.

(1) A block copy board B is attached to a square T by means of pins etc. to place it on the bed for mounting a block copy board. An image I of a pattern drawn on the original is projected thereon. A manipulation is implemented so that the rough sketch of the block copy board B corresponds to the image I of the pattern drawn on the original. It is here noted that the incidence therebetween is taken by moving the block copy board B incorporated with the square T without moving the original and thus changing its position or angle.

(2) With the square T being kept stationary, the original F is removed together with the holder H therefor and is pressed onto a reference surface of the square T. In this condition, the original F is attached on the square T by means of an adhesive tape etc. (FIG. 15).

(3) The square T to which the original F is attached is transferred onto a transparent film M in a manner that its angular position is not changed, thereafter to remove the original F from the square T to attach it on the film M (FIG. 16).

(4) The film M on which the original F is attached is wound along the surface the scanning drum D of the scanner thus to attach the film M on which the original F is attached on the scanning drum D (FIG. 17).

The latter method makes it possible to eliminate marking work required in respect to the block copy board or the original, but still requires a considerably large number of manual manipulations and further has drawbacks stated below.

a) Since it is required to attach the film M on which the original F is attached to the square, a precision cannot be ensured when a thin block copy board which is used. Accordingly, it is difficult to use its copy and therefore it is necessary to use a block copy board itself which is ordinarily provided as a pattern printed cardboard, resulting in difficulty in assurance of quality.

b) Punched holes are required in the block copy board, giving rise to changes thereof.

c) Skillfulness is required for ensuring a precision.

d) A large number of attaching and reattaching of an original are required, and therefore the original is likely to be damaged.

(EMBODIMENT)

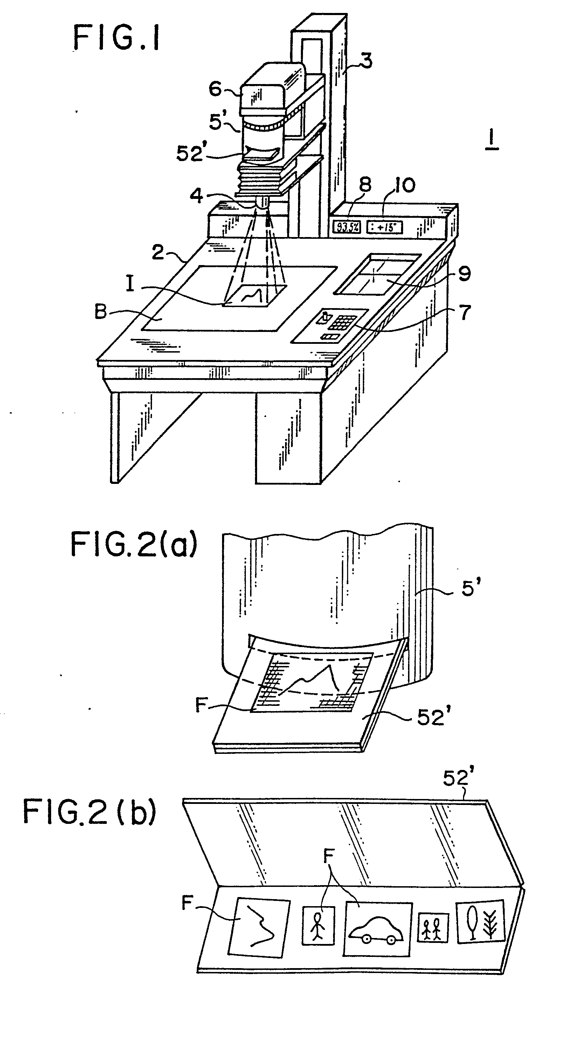

A preferred embodiment of an original angle setting device for a scanner according to the present invention will be described with reference to attached drawings FIGS. 1 to 9A.

FIG. 1 shows an embodiment of the original angle setting device according to the present invention. Referring to FIG. 1, an original angle setting device 1 for a scanner comprises a working stage 2, a post member 3 projected on the working stage 2, a projection lens 4, an original holder 5, a lamp house 6, a control panel 7, a magnification indicator 8, an X-Y plotter 9 and an angle indicator 10. Reference numerals B and I denote a block copy board and a projected image of an original. In this figure, an original holder employed in the present invention is denoted by reference numeral 5'. An original binder 52' is attached to the holder 5'.

FIGS. 2(a) and 2(b) show the relationship between the original holder 5' and the original holding member 52' and how the original F is held by the original holding member 52', respectively.

As shown in FIG. 2(b), the original binder 52' comprises two rectangular-shaped glass plates hingedly connected at each side edge portion. In use, with one glass plate being opened relative to the other, a desired number of original are placed on the other glass plate and then the one glass plate is closed to put the original between two glass plates.

The original holding member 52' in which the original F are held is inserted into a slit formed in the original holder 5' as shown in FIG. 2(a). The original holding member 52' is supported by the original holder 5' in a manner that the holding member 52' can be passed from one side to the other in a direction perpendicular to the axial direction of the original holder 5'. Accordingly, an adjustment of an inserted position of the original holding member 52' with respect to the original holder 5' makes it possible to successively effect angle setting measurement of the original F held by the original holding member 52'.

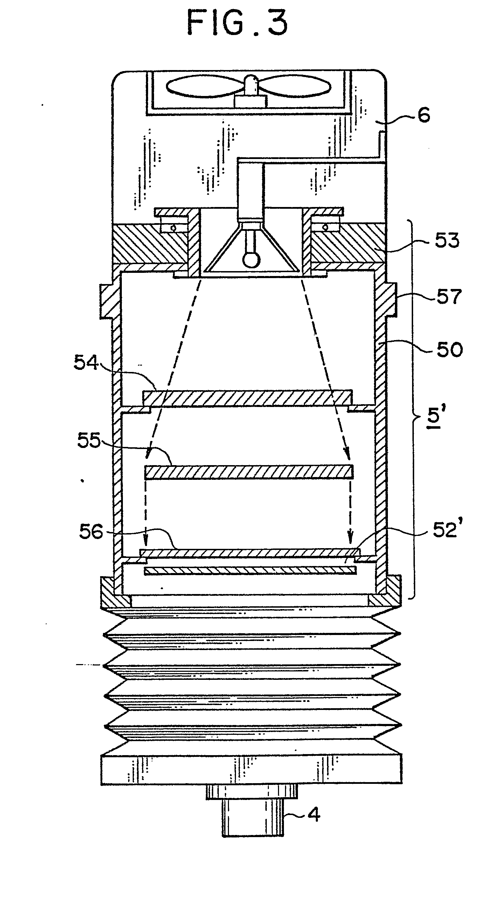

FIG. 3 shows a cross sectional view cut across the axis in respect to the light source box 6 and the original holder 5' in the embodiment shown in FIG. 1. A central portion of the configuration shown in FIG. 3 denotes the original holder 5'. The light source box 6 is provided above the original holder 5' and the lens unit 4 is provided therebelow. These members 4, 5' and 6 are supported so that they are in combination rotatable about the optical axis. The light source box 6 is provided with a fan for removing heat produced from a lamp or the like, and the lens unit 4 is provided with a projection lens and a bellows etc.

The original holder 5' is supported by a support portion 53 provided at the lower end of the light source box 2 and a heat wave absorption glass 54, a Fresnel lens 55 and a diffusion plate 56 are provided in succession from upward along the axis. The original holding member 52' is adapted to be inserted into a portion directly below the diffusion plate 56. With the configuration stated above, a light from a lamp provided within the light source box 6 is passed through the heat wave absorption glass 54 so that infrared components are eliminated. The light is converged by the Fresnel lens 55 and is diffused by the diffusion plate 56. The light thus diffused is exposed on the original held by the original holding member 52'. The light transmitted through the original is projected on the surface of the block copy board B (FIG. 1) through the lens unit 4.

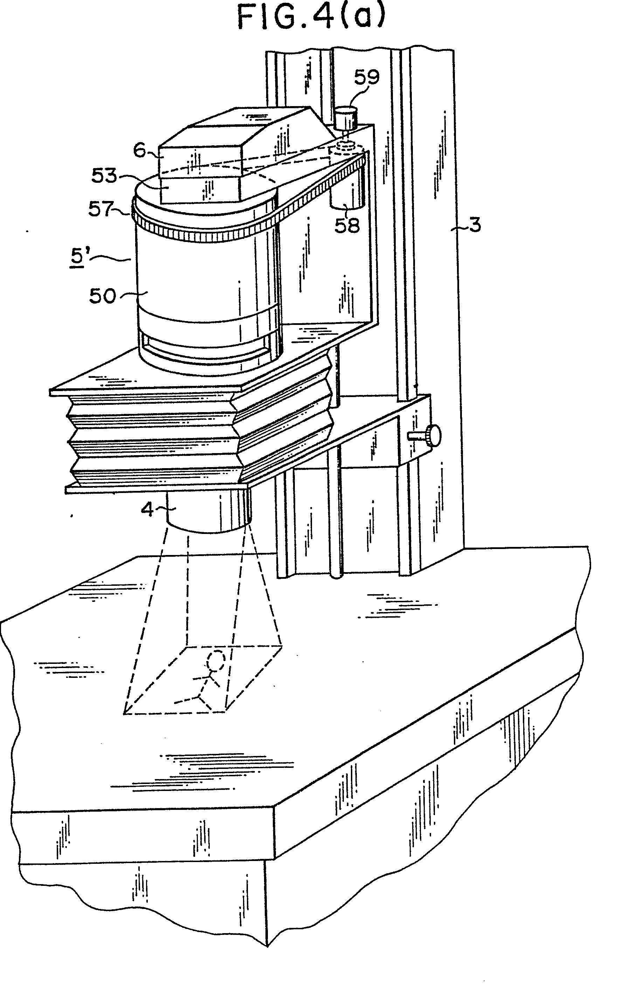

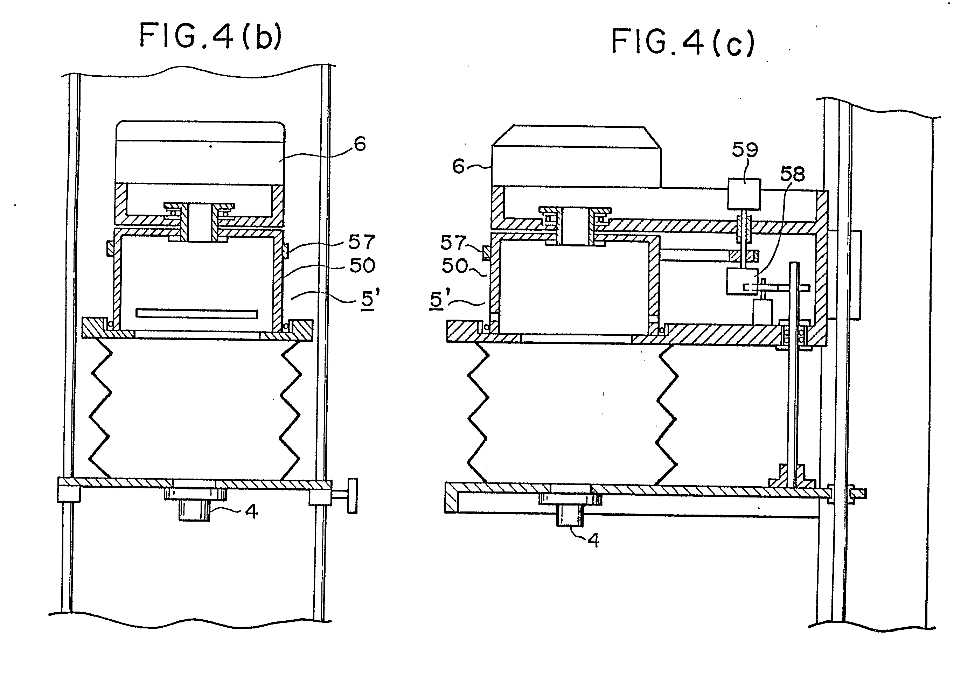

While observing the projected image, an operator will rotate the original holder 5' as described later. In order to provide a rotational drive power and measure a rotational angle, a belt 57 is at one end thereof wound onto a tubular member 50 constituting the original holder 5' and at the other end thereof wound by a drive/detection mechanism provided with a pulse motor 58 and a rotary encoder 59 (FIG. 4).

FIGS. 4(a), 4(b) and 4(c) show a rotational structure of the original holder 5' wherein FIG. 4(a) is a perspective view, FIG. 4(b) is a front cross sectional view cut across the optical axis when the original holder 5' is viewed in a front direction and FIG. 4(c) is a side cross sectional view cut in a similar manner to that of FIG. 4(b). As seen from these figures, the belt 57 wound onto the tubular member 50 of the original holder 5' is also wound onto a rotational axis of the drive/detection mechanism comprising the pulse motor 58 and the rotary encoder 59. The pulse motor 58 is connected so that it rotates when energized in accordance with the operation of the control panel 7 (FIG. 1). The rotational drive power is transmitted to the tubular member 50 of the original holder 5' through the belt 57. An amount of rotation of the pulse motor 58 is sensed by the rotary encoder 59 provided coaxially thereto.

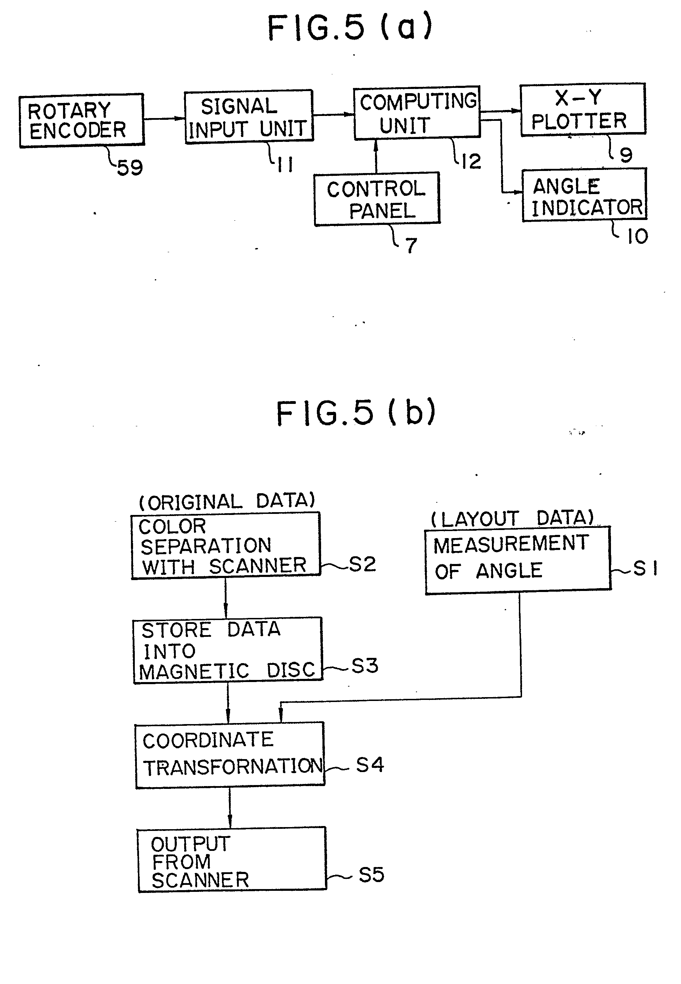

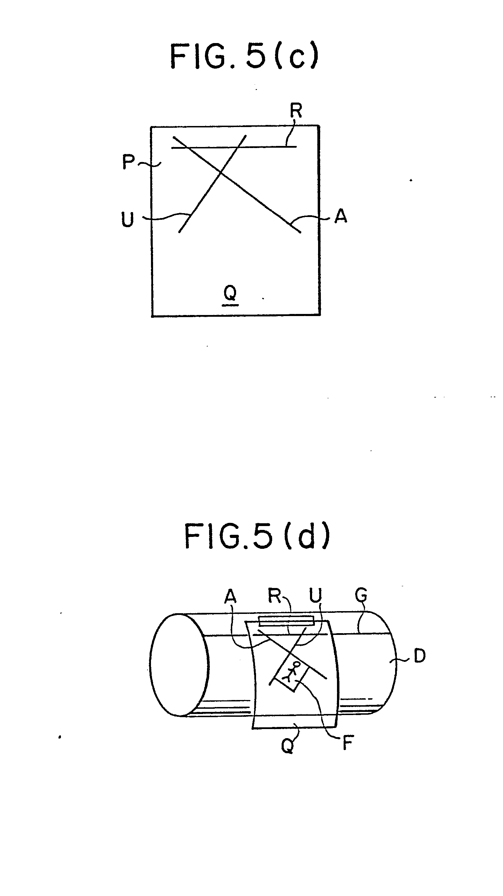

Referring to FIG. 5(a), there is shown detection circuit for sensing a rotational angle of the original holder. The rotary encoder produces a pulse signal indicative of a sensed rotational angle of the original holder. The pulse signal thus sensed is fed to a computing unit 12 through a signal input unit 11. The computing unit 12 effects computation of data input as the pulse signal through the signal input unit 11 in accordance with a computation command from the control panel (FIG. 1) to supply an output indicative of the computed result to X-Y plotter 9 and angle indicator 10 (which are shown in FIG. 10). FIG. 5(b) is a flowchart showing a coordinate transformation processing for original data. As shown in this figure, a value indicating an angle measured in the above-mentioned embodiment is input to a computer (not shown) (step S1). On the other hand, color separation is implemented under the condition where the original is aligned in a holizontal direction, i.e., it is not inclined (step S2). The original data is input to a magnetic disc and stored therein (S3). A rotational coordinate transformation processing is applied to the original data output from the magnetic disc (S4). Thus, an inclined original data as indicated by a block copy board is prepared. The date thus prepared can be output to a film etc. through a scanner (S5).

The coordinate transformation is effected using the equation shown below;

$$\begin{pmatrix} X_2 \\ Y_2 \end{pmatrix} = \begin{pmatrix} \cos\theta & \sin\theta \\ -\sin\theta & \cos\theta \end{pmatrix} \begin{pmatrix} X_1 \\ Y_1 \end{pmatrix}$$

where $X_2$ and $Y_2$ denote coordinates of an inclined original and $X_1$ and $Y_1$ denote coordinates of an original placed in a holizontal direction.

FIG. 5(c) shows an example of a hard copy output from the X-Y plotter 9. In this figure, a transparent film serving as a base member of the hard copy labelled by P. On the transparent film P, three straight lines labelled by R, A and U are depicted wherein R denotes a base line, A an angle indication or designation line and U a line perpendicular to the angle indication line A. An X-Y plotter which outputs a hard copy of a figure with such a transparent film being as a base member is well known in the art. The transparent hard copy, as shown in FIG. 5(c), output from the X-Y plotter 9 is called an "angle indication gauge" hereinafter, which is symboled by Q.

An angle setting of the original using the angle indication gauge Q will be described with reference to FIG. 5(d).

a) A manipulation is implemented so that the base line R of the angle indication gauge Q corresponds to the base line G depicted on the scanning drum D. In this condition, only the upper portion of the angle indication gauge Q is stuck onto the scanning drum D.

b) The original F is placed below the angle indication gauge Q so that it becomes in contact with the surface of the scanning drum D. In this condition, a manipulation is implemented so that the edge portions of the original F correspond to the angle indication line A and the line U perpendicular thereto depicted on the angle indication gauge Q, thus implementing positioning and angle adjustment.

c) With the original F being kept so that it is not displaced, the original F is stuck on the surface of the scanning drum D by means of an adhesive tape etc. thereafter to remove the angle indication gauge Q, thus completing angle setting of the original F.

Accordingly, in accordance with the embodiment stated above, any depiction of indication lines or marks etc. by hand is not required. As a result, the work becomes simplified and there is no possibility that precision is lowered due to hand-written depiction, thus facilitating to effect angle setting with a high precision.

Further, according to this embodiment, there is no requirement of resticking the original F, resulting in little possibility that the original F is stained or damaged and no requirement of providing holes in the block copy board B, thus enabling to effect an angle setting work using its copy.

In the above-mentioned embodiment, the pulse motor is used for rotating the original holder. It is needless to say that the pulse motor may be replaced by other electric drive means or a manual rotational mechanism etc. In addition, in stead of the belt, other means may be used as means for drivingly joining the original holder with the rotational mechanism.

As stated above, the original angle setting device according to the invention is characterized in that the original holding member is formed elongated so that a plurality of original can be held, and that a original holder into which the original holding member is inserted is configured so that the original holding member can be removably supported and rotated. Accordingly, this makes it possible to effectively carry out angle setting of a plurality of originals in succession.

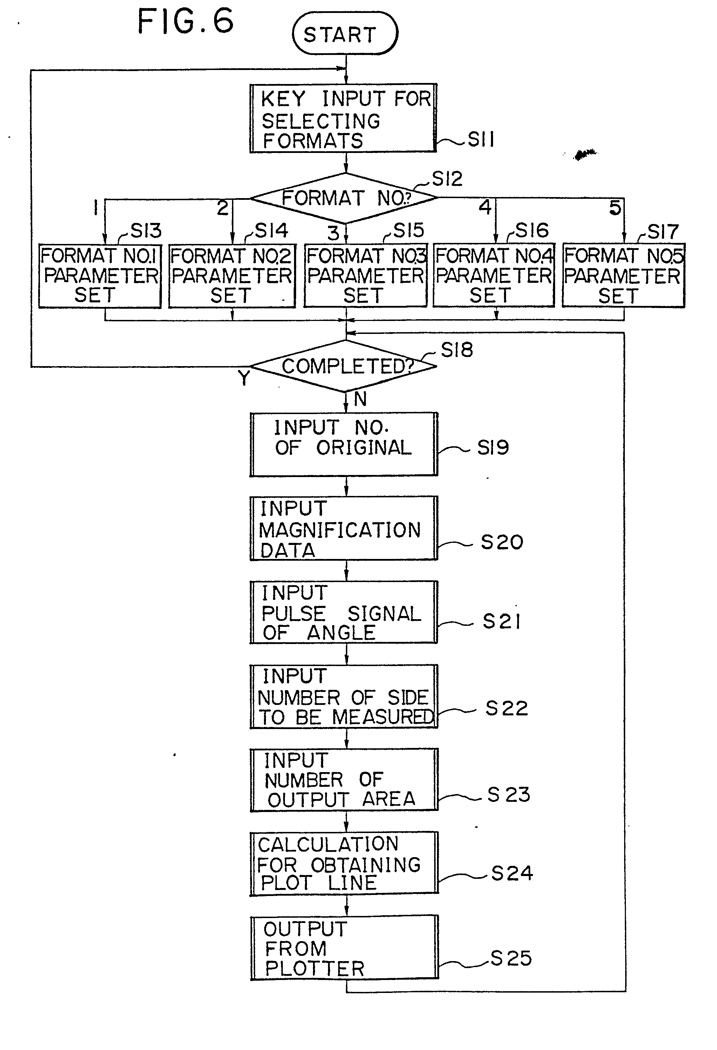

FIG. 6 is a flowchart showing another operation of the device shown in FIG. 5(a). The operation will be described in conjunction with this flowchart.

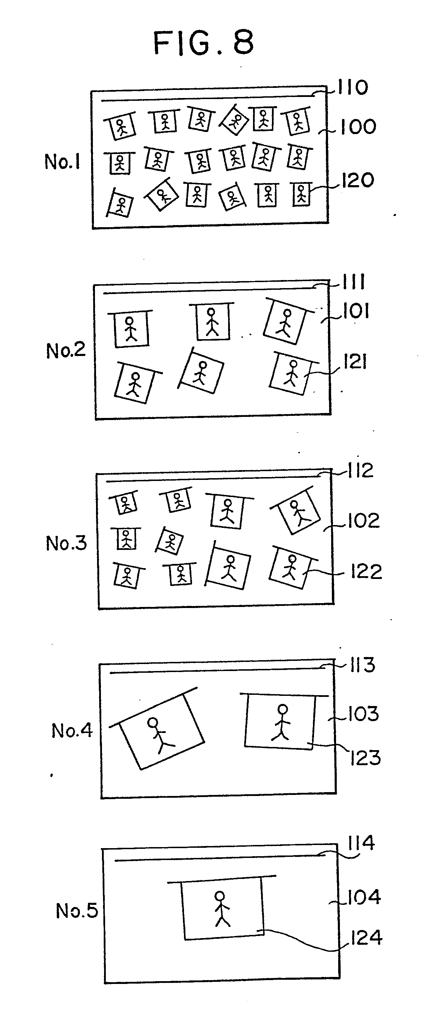

First, a key input for selecting one of formats is effected (step S11). In this embodiment, five kinds of formats (No. 1 to No. 5) are prepared in advance. As shown in FIG. 8, the No. 1 format is designated by reference numeral 100, which is formed by sticking eighteen films of 35 mm by 35 within a rectangular region of 300 mm broad by 180 mm long. Likewise, the No. 2 format is designated by reference numeral 101, which is formed by sticking six films of 6 cm by 6 within the same region; the No. 3 format is designated by reference numeral 102, which is formed by sticking six films of 35 mm by 35 and four films of 6 cm by 6; the No. 4 format is designated by reference numeral 103, which is formed by sticking two films of 4 inch by 5; and the No. 5 format is designated by reference numeral 104, which is formed by sticking one film of 300 mm by 180. Reference numerals 110 to 114 denote respective base lines on angle indication gauges which base lines correspond to a base line on the scanning drum, and reference numerals 120 to 124 denote originals stuck along sticking lines depicted on each film, respectively. These formats are desirable selected within a range of a paper size which can be plotted by a plotter incorporated in the original angle setting device.

Accordingly, when one of Keys assigned to the formats No. 1 to No. 5 is pressed (step S12), one of steps S13 to S17 is correspondingly selected. At this stage, there is no possibility that completion operation is not carried out, the step S18 is passed on and the operations indicated by the steps S19 to S25 are successively carried out. Namely, data indicative of a number assigned in advance to each original is input from the control panel 7 (S19), and then data indicative of magnification in regard to the selected original is input in a manner stated above (S20). Subsequently, a pulse signal indicative of angle of the original holder 5' assembled in the device shown in FIG. 1 is input (S21). Then, a number assigned to side to be measured is determined as will be described with reference to FIG. 9, and the number thus determined is input from the control panel 7 (S22). In addition a number assigned to each output area in the format is also input (S23).

Thus, the computation control unit 12 effect calculation for obtaining data corresponding to a line including a plot line i.e. a stick line based on these inputs (S24) to plot a predetermined stick line etc. at a predetermined position of the format by means of the X-Y plotter 9 (S25).

The operations indicated by the steps S19 to S25 are repeatedly carried out per each original. Thus, an original angle setting line etc. are plotted on portions of the format to complete an original stick angle indication gauge.

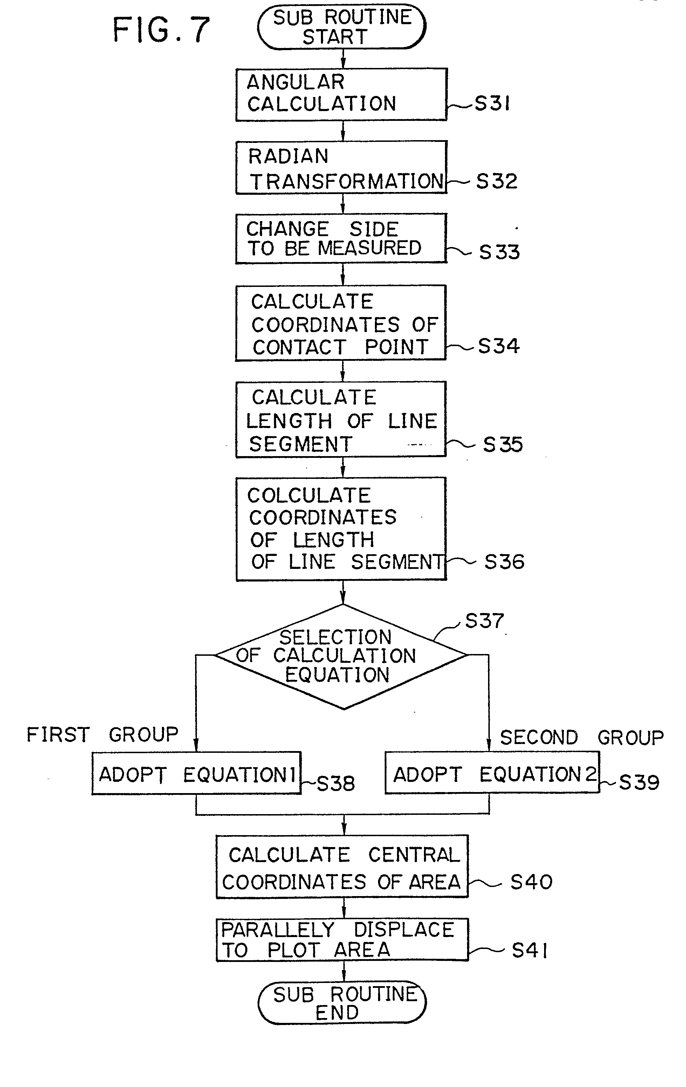

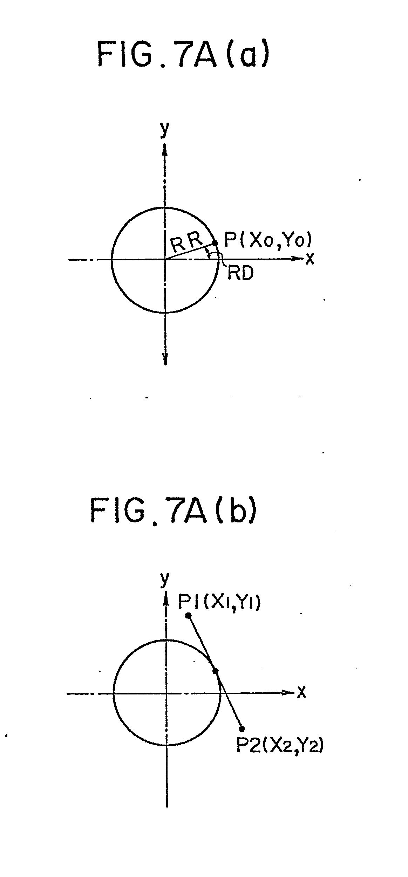

FIG. 7 is a flowchart showing the detail of the plot line calculation step (S24) shown in FIG. 6.

First, an angular cauculation is effected based on a pulse signal indicative of angle input in the step S31 in FIG. 6. Then, a radian transformation is effected in the step S32 to obtain data indicative of a line perpendicular to the side to be measured (S33).

Subsequently, a line segment RR connecting from the center of coordinate to a point at which a side to be measured and a line perpendicular to the side intersect with each other is obtained in X-Y coordinates shown in FIG. 7A(a) by making use of the line perpendicular to the side to be measured. Then, coordinates points (X0, Y0) in the center of the anti-coordinates of the line segment RR are obtained as contact point coordinates (S34). It is here noted that the contact point means a point at which a plot line is tangential to a circle shown in FIG. 7A(a) or 7A(b). Namely, the length of the line segment to be plotted is calculated based on the format and the number of the side to be measured with the contact point coordinates P (X0, Y0) being as a center (S35). The both ends coordinates of the line segment to be plotted is calculated based on the length of the line segment to be plotted (S36). The both coordinates exist at the both ends of a straight line successively extending by an equal length along the side to be measured with the contact point coordinates P (X0, Y0) being as a center. The both ends coordinates correspond to the coordinates P1 (X1, Y1) and P2 (X2, Y2) shown in FIG. 7A(b). Thus, a stick line is determined.

Then, a calculation equation is selected depending upon whether a format is formed by films of the same size or a format is formed so as to include films of different sizes (S37). When the format is formed by films of the same size or by a single film, the calculation equation 1 is adopted as a first group (S38). In contrast, when the format is formed in a manner that films of different sizes are included therein, the calculation equation 2 is adopted as a second group (S39).

FIGS. 9(a) and 9(b) show how a side to be measured of the original is selected and a setting line is plotted in accordance with the selection. The original is ordinarily rectangular-shaped. By utilizing one of four sides constituting the rectangle, the original is mounted. Which side is selected from four sides is dependent upon working efficiency. For such a side selection, numbers are attached to sides, respectively. In this example shown, the top side i.e. the top of the original is numbered 1 and other sides are clockwisely numbered 2, 3 and 4 as shown in FIG. 9(a). In addition, base lines for measuring angles of respective sides (1 to 4) are designated by reference numerals 131, 132, 133 and 134, respectively and angles defined by the sides 1 to 4 and the base lines 131 to 134 are labelled by $\theta_1$, $\theta_2$, $\theta_3$ and $\theta_4$, respectively. In these base lines, the base line 131 is a straight line having a reference angle of 0°, the base line 133 is a straight line parallel with the base line 131, and the base lines 132 and 134 are straight lines perpendicular to these base lines 131 and 133. Accordingly, the angles $\theta_2$ and $\theta_4$ measured in regard to the base lines 132 and 134 can be replaced by an angle in regard to e.g. the base line 131. With this angle being as angles in regard to the base line 200 set slightly above the base line 131, setting lines 201, 202, 203 and 204 are determined as shown in FIG. 9(b) to calculate the central coordinates of an area to be plotted (step S40), thus forming an output parallely displaced with respect to the area to be plotted (S41).

FIGS. 9A(a) and 9A(b) show a device configured in view of the above, which is disclosed in Japanese Patent Application No. 58-218736. Referring to FIG. 9A(a), an original angle setting device 1 for a scanner comprises a working stage 2, a post member 3 projected on the working stage 2, a projection lens 4, an original holder 5, a lamp house 6, a control panel 7, a magnification indicator 8, an X-Y plotter 9 and an angle indicator 10. Reference numerals B and I denote a block copy board and a projected image of an original.

The working stage 2 is adapted such that the block copy board B is mounted on the surface thereof to effectively carry out a magnification measurement work etc., and this state 2 serves as a base member for mounting the original angle setting device.

The projection lens 4, the original holder 5, and the lamp house 6 are supported by the post 3 as one unit, thus constituting a magnification measurement apparatus adapted so that the surface of the block copy board B mounted on the surface of the working stage 2 serves as an image projection surface of the original. The magnification measurement apparatus is configured such that the original attached to the original holder 5 is exposed by a light source (not shown) provided within the lamp house 6 through a suitable condensor lens (not shown), and a projected image I of a pattern of the original is projected onto the surface of the block copy board B. Further, the projection lens 4, the original holder 5, and the lamp house 6 are configured so that they are movable in the upper and lower directions along the post 3. Namely, these members 4, 5 and 6 are adapted so that they move upwardly and downwardly in accordance with the operation of a switch etc. provided on the control panel 7, thereby making it possible to focus on the surface of the block copy board B the projected image I obtained by reducing or expanding an image of the original to a desired size over a predetermined range. In addition, information indicative of a distance between the projection lens 4 and the block copy board B and information indicative of a distance between the projection lens 4 and the original are measured by using a linear encoder etc. to calculate a magnification based on a computing processing, thereby indicating the magnification thus calculated on the magnification indicator 8.

Accordingly, by setting an original to the magnification measurement apparatus thereby to form a projected image I on the surface of the block copy board B and then implementing a manipulation so that the projected image I corresponds to a rough sketch depicted on the block copy board B, a magnification can be automatically indicated on the magnification indicator 8. Thus, the magnification measurement is completed. Such an automatic magnification measurement apparatus is well known.

In the above-mentioned apparatus, the original holder 5 serving as a color original setting portion is provided with a handle 51 for rotating an original. A rotational angle of the original which is proportional to the rotational movement of the handle 51 is sensed by a rotary encoder (not shown) to feed a signal showing the rotational angle thus sensed to the angle indicator 10 to effect an angular display.

Thus, it is possible to provide an original angle indication gauge configured such that a setting line is depicted at a predetermined position of a predetermined format on the basis of a measured value of an angle of each original, and commands indicative of a side to be measured and indicative of output position which are independently input. Accordingly, this can carry out with a high efficiency original mounting work on a scanning drum of a scanner.

WHAT IS CLAIMED IS:

1. In an original angle setting device for a scanner wherein there is employed a system of setting an angle of the original on the basis of coincidence between a layout designation figure based on a block copy board and an optical projection image of a pattern formed on the original,

the improvement comprising:

a) rotational angle sensor means operative to produce an electric signal indicative of a rotational angle with respect to a predetermined angular position of the original with an optical axis of an optical system for projecting a pattern image of the original being as a rotational axis, and

b) figure plotting means operative to output a hard copy based on data electrically input, thereby allowing said figure plotting means to be operative on the basis of an angular data calculated based on said electric signal to obtain a hard copy figure serving as a reference for setting an original attachment angle with respect to said scanner.

2. An original angle setting device for a scanner as set forth in claim 1, wherein said rotational angle sensor means is comprised of a rotary encoder for sensing a rotational angle in a plane where said original is held by an original holder.

3. An original angle setting device for a scanner as set forth in claim 1, wherein said figure plotting means is comprised of an X-Y plotter.

4. An original angle setting device for a scanner as set forth in claim 1, wherein said hard copy figure is constituted with a transparent film serving as a base member.

5. An original angle setting device for a scanner as set forth in claim 1, wherein said hard copy figure is constituted with a paper serving as a base member.

6. An original angle setting device for a scanner as set forth in claim 1, which further comprises at least one of an analog indicator and a digital indicator to which said angular data is input.

7. An original angle setting device for a scanner as set forth in claim 1, wherein said optical system for projecting a pattern image of the original is used in common with a magnification measurement device for a scanner.

8. In an original angle setting device for a scanner wherein an original is inserted into an optical system to project an image of the original on a block copy board, thereby setting an angle of the original based on coincidence between the projected image and a layout designation figure formed on said block copy board,

the improvement comprising

a) original holding member formed rectangular-shaped so that an original can be held,

b) a rotatable original holder for removably supporting said original holding member,

c) sensor means for sensing a rotational angle of said original holder, and

d) means operative to produce an output indicating a rotational angle of said original holder based on an output from said sensor means.

9. An original angle setting device for a scanner as set forth in claim 8, wherein said rotational angle sensor means is comprised of a rotary encoder.

10. An original angle setting device for a scanner as set forth in claim 8, wherein said rotational angle sensor means is joined to said original holder by means of a belt.

11. An original angle setting device for a scanner as set forth in claim 8, wherein said original holder is rotatabley driven by a pulse motor.

12. An original angle setting device for a scanner as set forth in claim 8, wherein said output means is an X-Y plotter which plots a base line for setting an original attachment angle with respect to said scanner.

13. In an original angle setting device for a scanner wherein an original is inserted into an optical system to project an image of the original on a block copy board, thereby setting an angle of the original based on coincidence between the projected image and a layout designation figure formed on said block copy board,

the improvement comprising

a) original holding member formed rectangular-shaped so that a plurality of original can be held,

b) a rotatable original holder for removably supporting said original holding member,

c) sensor means for sensing a rotational angle of said original holder, and

d) means operative to produce an output indicating a rotational angle of said original holder based on an output from said sensor means.

14. An original angle setting device for a scanner as set forth in claim 13, wherein said rotational angle sensor means is comprised of a rotary encoder.

15. An original angle setting device for a scanner as set forth in claim 13, wherein said rotational angle sensor means is joined to said original holder by means of a belt.

16. An original angle setting device for a scanner as set forth in claim 13, wherein said original holder is rotatabley driven by a pulse motor.

17. An original angle setting device for a scanner as set forth in claim 13, wherein said output means is an X-Y plotter which plots a base line for setting an original attachment angle with respect to said scanner.

18. A device for making an original angle indication gauge for a scanner comprising:

a) means adapted to set an original thereafter to implement a rotational manipulation by an angle designated by a layout designation board, thus forming an original angle signal,

b) manipulating means for inputting a number corresponding to a specified one side among four sides of the original and a number corresponding to a specified position in a predetermined format,

c) computational control means in which plotting parameters including predetermined formats and output central coordinates are stored, said computation means operative to effect computation based on each output from said original angle signal forming means and said manipulating means to output data in regard to an original setting line, and

d) means operative to output data for making an angle indication gauge in which said setting line is plotted in accordance with said output from said computational control means.

0169967

FIG.1

3
6
5'
52'
1
8
10
4
93.5%
+15°
2
9
I
B
7

FIG.2(a)

5'
F
52'

FIG.2(b)

52'
F
F

FIG. 3

6
53
57
50
54
55
56
52'
5'
4

0169967

FIG.4(a)

59
6
53
57
58
3
5'
50
4

FIG.4(b)

6
57
50
5'
4

FIG.4(c)

58
59
6
57
50
5'
4

FIG.5 (a)

ROTARY ENCODER
59
SIGNAL INPUT UNIT
11
COMPUTING UNIT
12
CONTROL PANEL
7
X-Y PLOTTER
9
ANGLE INDICATOR
10

FIG.5 (b)

(ORIGINAL DATA)
COLOR SEPARATION WITH SCANNER
S2
(LAYOUT DATA)
MEASUREMENT OF ANGLE
S1
STORE DATA INTO MAGNETIC DISC
S3
COORDINATE TRANSFORMATION
S4
OUTPUT FROM SCANNER
S5

FIG. 5(c)

R
P
U
A
Q

FIG.5(d)

A
R
U
G
D
Q
F

FIG.6
START
KEY INPUT FOR SELECTING FORMATS
S11
FORMAT NO.?
S12
1
2
3
4
5
S13
S14
S15
S16
S17
FORMAT NO.1 PARAMETER SET
FORMAT NO.2 PARAMETER SET
FORMAT NO.3 PARAMETER SET
FORMAT NO.4 PARAMETER SET
FORMAT NO.5 PARAMETER SET
COMPLETED?
S18
Y
N
INPUT NO. OF ORIGINAL
S19
INPUT MAGNIFICATION DATA
S20
INPUT PULSE SIGNAL OF ANGLE
S21
INPUT NUMBER OF SIDE TO BE MEASURED
S22
INPUT NUMBER OF OUTPUT AREA
S23
CALCULATION FOR OBTAINING PLOT LINE
S24
OUTPUT FROM PLOTTER
S25

0169967

FIG. 7
SUB ROUTINE START
ANGULAR CALCULATION
S31
RADIAN TRANSFORMATION
S32
CHANGE SIDE TO BE MEASURED
S33
CALCULATE COORDINATES OF CONTACT POINT
S34
CALCULATE LENGTH OF LINE SEGMENT
S35
COLCULATE COORDINATES OF LENGTH OF LINE SEGMENT
S36
SELECTION OF CALCULATION EQUATION
S37
FIRST GROUP
SECOND GROUP
ADOPT EQUATION1
S38
ADOPT EQUATION2
S39
CALCULATE CENTRAL COORDINATES OF AREA
S40
PARALLELY DISPLACE TO PLOT AREA
S41
SUB ROUTINE END

FIG. 7A (a)

y
RR
P(Xo,Yo)
x
RD
y

FIG. 7A (b)

y
P1(X1,Y1)
x
P2(X2,Y2)

0169967

FIG. 8

110
100
No.1
120

111
101
No.2
121

112
102
No.3
122

113
103
No.4
123

114
104
No.5
124

FIG. 9 (a)

FIG. 9 (b)

131
θ1
1
132
2
θ2
3
θ3
133
134
θ4
4
200
201
1
200
202
2
200
203
3
200
4
204

FIG. 9A(a)

3
6
5
51
4
8
10
1
935%
+17°
2
9
I
B
PLOTER
7

FIG. 9A(b)

52a
5
F
52b

0169967

FIG. 10
PRIOR ART

B
I


FIG. 11
PRIOR ART

I
B
L
L


FIG. 12
PRIOR ART

M
F
F
B
L
L

0169967

FIG.13

PRIOR ART

D
F
G
S

FIG.14

PRIOR ART

I
B
T

FIG.15

PRIOR ART

T
H
F

FIG.16

PRIOR ART

M
T
F

FIG.17

PRIOR ART

F
D
M